# EUROPEAN PATENT APPLICATION

(11) **EP 2 317 537 A1**
(43) Date of publication of application: **04.05.2011**
(21) Application number: 09174533.1
(22) Date of filing: 29.10.2009
(51) Int. Cl.: H01J 37/34, C23C 14/35

(54) **Sputter deposition system and method**

(71) Applicant: Applied Materials, Inc., Santa Clara, CA 95054 (US)
(72) Inventor: Lopp, Andreas, 63579 Freigericht (DE); Bender, Marcus, 63454 Hanau (DE)
(74) Representative: Zimmermann & Partner

(57) **Abstract**

A sputter deposition system adapted for depositing a thin film onto a substrate surface is provided. The system includes a cathode assembly having at least two cathode targets opposing the substrate surface and adapted for providing cathode material for forming the thin film. A plasma source is adapted for generating a plasma for sputtering cathode material off the at least two cathode targets. A magnetic field generator is adapted for providing a magnetic field which is controllable independently of the plasma source such that such that a difference between high deposition rate portions and low deposition rate portions is compensated by the action of the magnetic field on charged particle movements.

## Description

### TECHNICAL FIELD OF THE INVENTION

Embodiments of the present invention relate to a plasma-assisted deposition system for depositing a thin film onto a substrate surface. In particular, embodiments of the present invention relate to a sputter deposition system including cathode targets which provide the deposition material for depositing the thin film onto the substrate surface. Furthermore, embodiments of the present invention relate to a method for depositing a thin film onto a surface of a substrate using plasma in low pressure conditions.

### BACKGROUND OF THE INVENTION

Plasma-assisted surface processes provide a powerful tool for depositing thin films onto substrates. This type of thin film deposition has many applications, e.g. in the microelectronic industry, for depositing photovoltaic layers onto flexible substrates, for modifying surfaces of substrates in general, etc. Many applications of thin films deposited from a plasma rely upon an adequate film homogeneity. During the deposition process, e.g. film composition, film thickness and film thickness variation are parameters which may be adjusted, monitored and controlled. In particular, film thickness homogeneity is an issue in deposition processes for large area substrates.

In sputter deposition processes, deposition material for forming the thin film onto a substrate surface may be provided by individual cathode targets having the desired deposition material. During the deposition process at least a part of the cathode material is sputtered off the cathode targets. While an individual cathode target may provide deposition material for a limited local deposition area, an extension of the substrate surface to be coated may be much larger than this local deposition area. Thus an array of cathode targets may be employed to cover larger deposition areas. A film thickness variation may occur in such kind of arrayed cathode target arrangement due to an inhomogeneity in film deposition conditions. The film thickness may be higher at a substrate surface location near an individual cathode target or opposing an individual cathode target, whereas the film thickness may be lower at other surface areas, e.g. at areas where the distance between an individual cathode target and the substrate surface to be coated is increased.

Individual sources of deposition material which are arranged at local positions within a sputter deposition process and which have a limited spatial extension, such as cathode targets in a sputter deposition process, result in varying deposition rates across a substrate surface. For coating large area substrates, however, a uniform layer thickness is desired.

### SUMMARY OF THE INVENTION

In light of the above, a sputter deposition system for depositing a thin film onto a substrate surface according to independent claim 1 and a method for depositing a thin film onto a surface of a substrate according to independent claim 13 are provided.

According to one embodiment, a sputter deposition system adapted for depositing a thin film onto a substrate surface is provided, the system including a cathode assembly including at least two cathode targets opposing the substrate surface and adapted for providing cathode material for forming the thin film, a plasma source adapted for generating a plasma for sputtering cathode material off the at least two cathode targets, wherein two or more high rate deposition volumes are defined between portions of the substrate surface opposing a respective cathode target and the cathode target, and wherein a low rate deposition volume is defined between the two adjacent high rate deposition volumes, and a magnetic field generator adapted for providing a magnetic field which is controllable independently of the plasma source such that magnetic field lines extend substantially parallel to the substrate surface in at least portions of the high rate deposition volumes.

According to a further embodiment, a method for depositing a thin film onto a surface of a substrate is provided, the method including steps of providing a cathode assembly including at least two cathode targets, arranging the substrate in the vicinity of the cathode assembly, wherein the substrate surface opposes the cathode assembly, generating a plasma in a plasma volume between the cathode assembly and the substrate, sputtering, by means of the generated plasma, cathode material off the at least two cathode targets and depositing sputtered cathode material onto the substrate surface in a deposition direction with a high deposition rate in high rate deposition portions of the substrate surface which are opposing respective cathode targets, and with a low deposition rate in a low rate deposition portion between the two adjacent high rate deposition portions of the substrate surface, and applying a magnetic field in the plasma volume such that the difference between the high deposition rate and the low deposition rate is compensated.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: shows a schematic side view of a sputter deposition system having a cathode assembly and a magnetic field generator, according to a first embodiment;
- Figure 2: is a schematic side view of the sputter deposition system shown in Fig. 1, including a cooling plate, according to another embodiment;
- Figure 3: is a graph illustrating traces of charged particles propagating on the basis of a magnetic field distribution;
- Figure 4: is a side sectional view of a sputter deposition system according to a further embodiment;
- Figure 5: is a side view of the sputter deposition system shown in Fig. 4 including a cooling plate;
- Figure 6: is a graph illustrating traces of charged particles propagating on the basis of a magnetic field generated by a magnetic field generator included in the sputter deposition system shown in Fig. 4;
- Figure 7(a): is a schematic view of a sputter deposition system having a cathode assembly with a plurality of cathode targets and a magnetic field generator having a plurality of permanent magnets;
- Figure 7(b): is a graph showing layer thickness variations generated on the basis of an applied magnetic field; and
- Figure 8: is a flowchart illustrating a method for depositing a thin film onto a surface of a substrate, according to yet another embodiment.

### DETAILED DESCRIPTION OF THE EMBODIMENTS

Reference will now be made in detail to the various embodiments of the invention, one or more examples of which are illustrated in the drawings. Within the following description of the drawings, the same reference numbers refer to the same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a sputter deposition system adapted for depositing a thin film onto a substrate surface. The sputter deposition system may include a cathode assembly having at least two cathode targets opposing the substrate surface to be coated and adapted for providing cathode material for forming the thin film. As the individual cathode targets of the cathode assembly are limited in space, e.g. a surface of an individual cathode target opposing the substrate surface to be coated is much smaller than the area of the substrate surface to be coated, a non-uniformity of a film thickness deposited onto the substrate surface may occur.

In sputter deposition systems, a plurality of cathode targets are provided in a cathode assembly, such that a deposition of material onto larger deposition areas or substrate surfaces may be provided. Nevertheless, high rate deposition volumes may occur between portions of the substrate surface opposing a respective cathode target and the cathode target, wherein low rate deposition volumes may occur between adjacent high-rate deposition volumes. Using such kind of sputter deposition system having an arrayed cathode target arrangement, for forming a thin film onto a substrate surface, may result in a thickness inhomogeneity due to the different deposition rates.

During a sputter deposition process, high energy particles, e.g. ionized atoms from a plasma, impinge onto the cathode targets and sputter deposition material off an individual cathode target. The sputtered cathode material then is deposited as a thin film onto the substrate surface.

According to a first embodiment, a magnetic field generator is provided which is adapted for generating a magnetic field. The magnetic field is controllable independently of the plasma source such that magnetic field lines may extend, at least partially, parallel to the substrate surface in at least portions of one or more high rate deposition volumes. If the magnetic field lines extend substantially parallel to the substrate surface, a propagation of charged particles in directions perpendicular to the extension of the magnetic field lines is restricted due to the action of Lorentz forces. Thus, an intensity and/or direction of a magnetic field in volumes between portions of the substrate surface and respective cathode targets may influence a respective deposition rate and thus a layer thickness distribution of a thin film deposited onto the substrate surface.

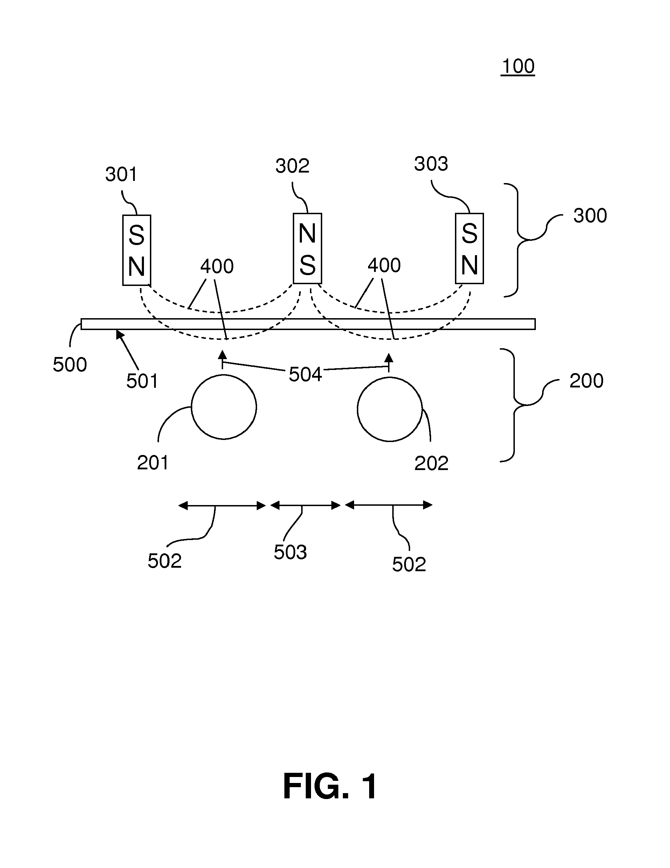

Fig. 1 is a schematic side sectional view illustrating a sputter deposition system adapted for depositing a thin film onto a substrate surface, according to a first embodiment. The sputter deposition system 100 includes a cathode assembly 200 having a first cathode target 201 and a second cathode target 202. It is noted here that the embodiment is not limited to two cathode targets, rather a plurality of cathode targets larger than two may be provided for the sputter deposition system 100. Moreover, the array of cathode targets 201, 202 may extend in a line, or may be provided as a two-dimensional arrangement. In addition to that, one or more of the cathode targets of the cathode assembly 200 may be provided as rotary cathodes. A rotary cathode is a cathode which rotates about an axis which may be approximately parallel to the substrate surface. Due to the rotation of the rotary cathode, during the sputter deposition process material is sputtered off the cathode target in more homogenous manner such that deposition material is removed from the cathode target uniformly with respect to the target surface.

In order to simplify the explanation herein below, the first cathode target 201 and the second cathode target 202 will be described with respect to a procedure for depositing a thin film onto the surface 501 of a substrate 500. The substrate 500 may include a large area which may be coated by a thin film and the substrate 500 may extend in a direction perpendicular to the plane of drawing.

For depositing a thin film onto the front surface 501 of the substrate 500, a variety of plasma-assisted deposition processes may be applied. For a sputter deposition process, the cathode assembly 200 may include a one-dimensional or a two-dimensional array of cathode targets 201, 202. The sputter deposition system 100 may include a plasma source (not shown in Fig. 1). The cathode targets 201, 202 may be formed as magnetrons.

For deposition processes, the cathode of a magnetron may be provided as at least one of the sputter cathode targets 201, 202 shown in Fig. 1. Magnetron sputter processes are appropriate processes for a reactive and a non-reactive deposition of thin films onto the surface 501 of the substrate 500. In a reactive sputter deposition process, a chemical reaction is provided at the cathode target in addition to physical sputtering of target atoms or molecules off respective cathode targets 201, 202. Ions originating from a plasma in a plasma-assisted process sputter cathode target material which in turn may be ionized. Thus, the sputtered material may be subject to an influence of a magnetic field generated by a magnetic field generator 300. The magnetic field generated by the magnetic field generator 300 may provide a shielding of predetermined portions of the substrate surface 501 from incoming charged particles of deposition material. In order to provide such kind of magnetic shielding the direction and/or the intensity of the magnetic field may be controlled. Due to the action of Lorentz forces the travel of charged particles in directions perpendicular to the magnetic field lines is restricted.

The magnetic field generator 300 is arranged behind the substrate 500, i.e. at a side of the substrate 500 opposing the side at which the cathode assembly 200 is arranged. The magnetic field generator may include at least one magnetic element of the group consisting of: a permanent magnet, an electromagnetic coil, and a combination thereof. The magnetic field generator 300 shown in Fig. 1 includes a number of permanent magnets 301, 302, 303 arranged such that a desired magnetic field is generated. A cathode target spacing, i.e. a distance between adjacent cathode targets 201, 202 may correspond to a spacing of the magnetic elements 301, 302, 303.

The configuration of the magnetic field will be described herein below with respect to a deposition of homogeneous thin films onto the surface 501 of the substrate 500. A layer thickness distribution of a thin film deposited on the surface 501 may be influenced by means of an appropriate magnetic field. For example, in a sputter deposition process the movement of charged particles is influenced by magnetic fields generated by magnets or coils behind the substrate.

In particular the magnetic field may act directly on an ionized part of the incoming particles. The magnetic field provided by an array of permanent magnets 301, 302, 303 or by magnetic coils may be represented by respective magnetic field lines 400 along which charged particles predominantly propagate. Due to the action of Lorentz forces a travel direction of the charged particles can be seen as to correspond to the direction of the magnetic field lines 400.

Using a magnetic field for controlling a movement of an ionized part of incoming particles, the influence on the incoming particles is based on a ratio q/m, wherein q represents a charge of a specific ionized particle (ionized atom, ion or ionized molecule), and m represents the mass of the incoming particle.

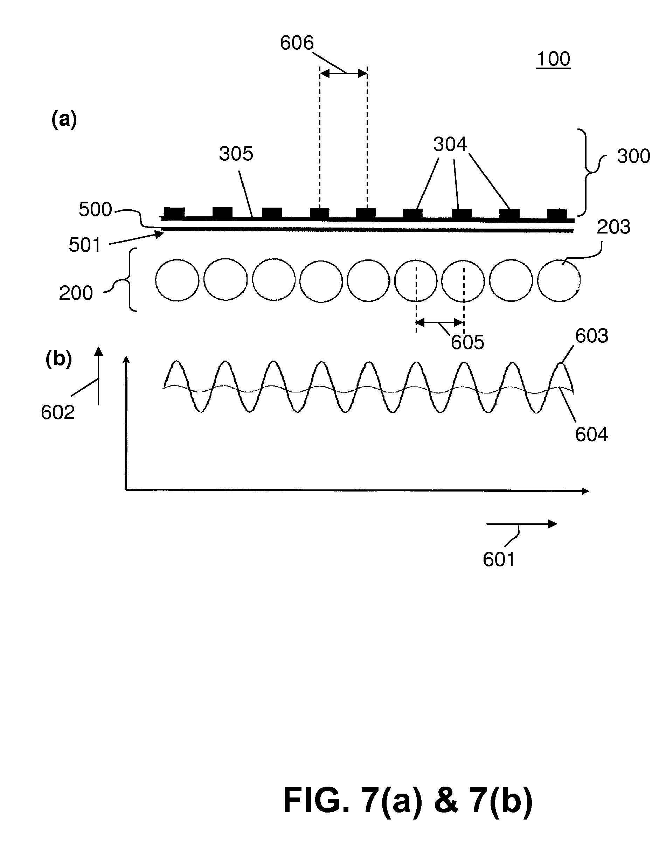

Without applying a magnetic field, a sputter deposition process using the individual, local cathode targets 201, 202 will provide a deposited film the layer thickness of which is inhomogeneous due to the limited spatial extension of the cathode targets 201, 202. Thus, a layer inhomogeneity, i.e. a periodically changing thickness, is obtained (see also description with respect to Fig. 7 herein below). The arrangement of the permanent magnets 301, 302, 303 of the magnetic field generator 300 shown in Fig. 1 is such that at least a portion of the magnetic field lines 400 extends substantially parallel to the substrate surface opposing an individual cathode target 201, 202. Specifically, the magnetic field generator 300 is adapted for providing a magnetic field which is controllable independently of the plasma source such that magnetic field lines 400 extend at least partially parallel to the substrate surface 501 in portions of the substrate surface.

The plasma source is adapted for generating a plasma for sputtering cathode material off the cathode targets 201, 202. A high rate deposition volume may be defined as a volume between portions of the substrate surface 501 opposing a respective cathode target 201, 202 and the cathode target 201, 202, such as a portion as indicated by a reference numeral 502. Thus a high rate deposition volume is defined at a high deposition portion.

A low deposition portion 503 is defined between two adjacent high deposition portions 502, such that a low rate deposition volume is located between two high deposition volumes. In at least portions of the high deposition volumes, magnetic field lines 400 extend substantially parallel to the substrate surface 501.

High deposition portions 502 of the substrate surface 501 having magnetic field lines 400 parallel to the substrate surface 501 of the substrate 500 are protected from incoming ions, at least partially, such that the layer thickness is decrease in this portion. The layer thickness will be increased in regions where the magnetic field lines 400 are oriented in directions other than parallel with respect to the substrate surface 501. If an ionization fraction of particles sputtered off the cathode targets 201, 202 is in a range from 5% to 20%, variations in a layer thickness uniformity of a magnitude in a range from ±5% to ±10% may be compensated.

It is noted here that, in order to provide clarity, only a few magnetic field lines 400 at the substrate surface 501 are shown in Fig. 1. In a case where magnetron sputter deposition processes are applied, the magnetron plasma source itself generates a magnetic field which may have magnetic field lines 400 parallel to portions of the substrate surface 501. The magnetic field provided by the magnetic field generator 300 shown in Fig. 1, however, is controllable independently of the magnetron plasma source such that magnetic field lines 400 may be adjusted to extend substantially parallel to the substrate surface in at least portions of the high rate deposition volumes.

A main deposition direction is indicated by arrows 504 indicating a transport direction of sputtered cathode material towards to the substrate surface 501. As can be seen in Fig. 1, a larger amount of material is transported towards the substrate surface 501 in the high deposition portions 502 compared to a material transport in the low deposition portion 503.

The application of the magnetic field includes providing magnetic field lines 400 extending perpendicular to the deposition direction 504 in the high rate deposition portions. It is noted here that the magnetic field may be controlled with respect to a magnetic field direction and/or a magnetic field strength by means of the magnetic field generator 300.

A variation of the magnetic field strength, i.e. the magnetic field intensity, may be provided by varying a distance of the magnetic field generator 300 with respect to the side of the substrate 500 opposing the front surface 501 to be coated. The magnetic field direction may be adjusted an adjustment of an orientation of the magnetic field generator 300 with respect to the substrate surface 501.

A thin film deposition process provided by the sputter deposition system 100 shown in Fig. 1 may include steps selected from the group consisting of: depositing a uniform thin film onto the substrate surface, depositing a layer stack onto the substrate surface, non-reactive processing of the substrate surface, reactive processing of the substrate surface, and any combination thereof.

The magnetic field generator 300 may include at least one magnetic element of the group consisting of: a permanent magnet 301, 302, 303, an electromagnetic coil and a combination thereof.

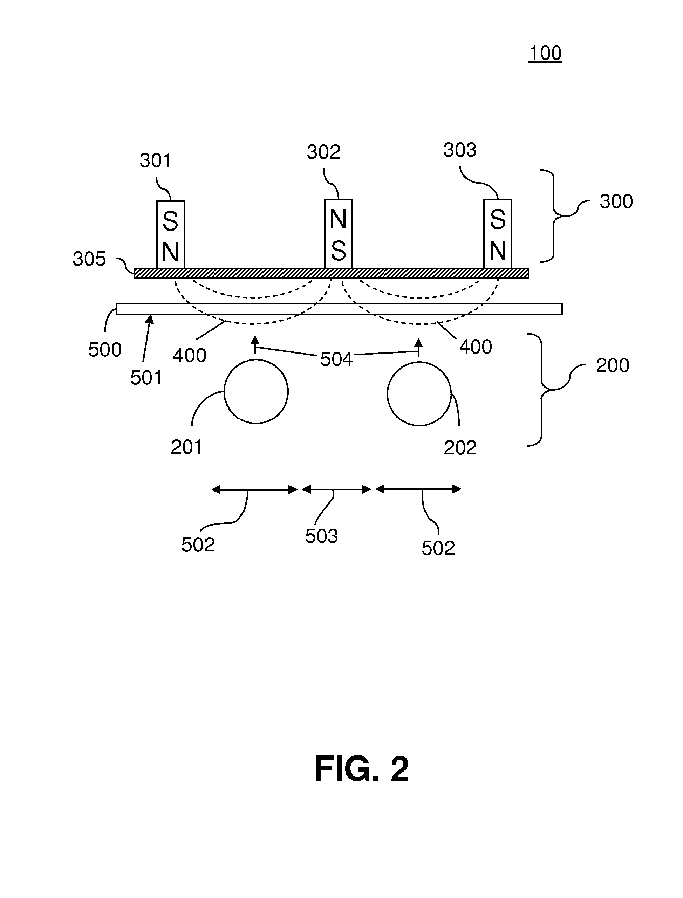

Fig. 2 is a schematic side sectional view of a sputter depositions system 100 in accordance with a further embodiment. As shown in Fig. 2, a cooling plate 305 is arranged between the magnetic field generator 300 and the side of the substrate 500 opposing the surface 501 to be coated. The cooling plate 305 arranged between the magnetic field generator 300 and the position of the substrate 500 is adapted for providing a thermal isolation between the magnetic field generator 300 and the substrate deposition portion of the sputter deposition system 100.

The cathode assembly 200 may be operated at high temperatures such that the magnetic field generator 300 is thermally isolated by means of the cooling plate 305. The magnetic elements 301, 302, 303 of the magnetic field generator 300 are arranged at the cooling plate 305 such that an alternating magnetic field orientation of two adjacent magnetic field elements is provided. Albeit permanent magnets N-S are shown to form the magnetic field elements, electromagnetic coils can be used instead.

It is noted here that components and parts which have been described with respect to the previous Fig. 1 are not detailed in the description with respect to the following figures in order to avoid a redundant description.

A magnetic field strength of the magnetic field provided by the magnetic field generator 300 may be varied by varying a distance between the magnetic field generator 300 and the cathode assembly 200. In particular, the magnetic field strength is decreased with increasing distance from the cathode assembly 200. The magnetic field may be applied such that at least a sub volume of the plasma volume adjacent to at least one high rate deposition portion of the substrate is penetrated by a high density of magnetic field lines 400, i.e. by a magnetic field having a high magnetic field strength, wherein the remaining plasma volume is penetrated by a low density of magnetic field lines 400, i.e. by a magnetic field having a low magnetic field strength. It is noted herethat the term "high density of magnetic field lines" denotes a magnetic field having a high magnetic field intensity whereas the term "low density of magnetic field lines" denotes a magnetic field having a low magnetic field intensity. Thus the representation of a magnetic field in the form of magnetic field lines is, as illustrated in some of the drawings, an appropriate means for indicating the magnetic field direction and the magnetic field intensity.

Furthermore, the magnetic field may be adjusted such that the sub volume extends from at least one high rate deposition portion of the substrate surface towards an opposing cathode target 201, 202 and includes a volume in a range from 30% to 70%, and typically includes a volume of approximately 50%, of the plasma volume.

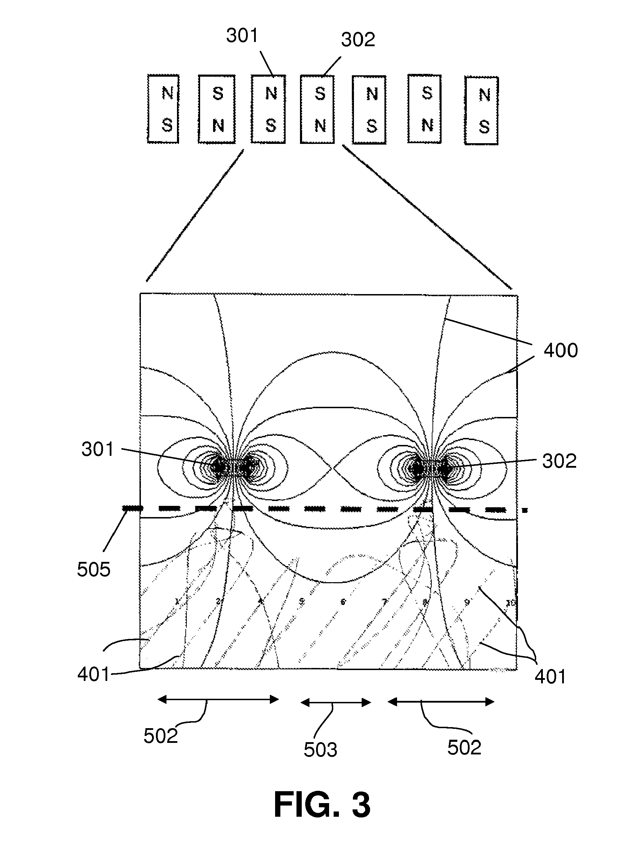

Fig. 3 is a graph illustrating traces 401 of charged particles, wherein the traces are curved due to the action of the magnetic field generated by the magnetic field generator, i.e. the first permanent magnet 301 and the second permanent magnet 302, respectively. The magnetic field lines 400 resulting from the interaction of the two permanent magnets 301, 302 are shown as solid lines 400, wherein the charged particle traces 401 are shown as dotted and dash-dotted lines, respectively.

Whereas charged particles may travel along magnetic field lines 400, a movement which is substantially perpendicular to a magnetic field line is restricted due to the magnetic force acting on the charged particles. As can be seen from the simulation shown in Fig. 3, e.g. charged particles 1, 2 which essentially move parallel to the magnetic field line 400 propagate much farther towards the substrate surface than charged particles 4, 5 which move towards the surface at a location between the two permanent magnets.

As shown in Fig. 2, the arrangement of the cathode assembly 200 is such that the first and second cathode targets 201, 202 are located opposite the substrate surface 501 to be coated in a region where the magnetic field lines 400 are essentially perpendicular to the deposition direction 504.

Thus, a deposition rate at a location in the high deposition portion 502 between two adjacent permanent magnets 301, 302 is decreased, whereas charged particles of the deposition material can reach the substrate surface 501 to be coated much easier in the low deposition portion 503. High rate deposition volumes are defined between portions of the substrate surface opposing a respective cathode target 201, 202 and the magnetic field lines 400 are arranged such that their orientation is substantially perpendicular to the deposition direction 504 in the high deposition portions 502. Low rate deposition volumes are respectively defined between the two adjacent high rate deposition volumes. Thus, the magnetic field generator 300 is adapted to provide the substantially parallel magnetic field lines 400 penetrating the high rate deposition volumes at or near the substrate surface 501.

As shown in Fig. 3, two adjacent permanent magnets 301, 302 are arranged such that magnetic field orientations of the two adjacent permanent magnets 301, 302 are anti-parallel to each other and approximately perpendicular to the substrate surface 501. If such kind of anti-parallel arrangement is provided between two adjacent magnetic elements, i.e. between two adjacent permanent magnets 301, 302, a magnetic field distribution as shown in the graph of Fig. 3 is obtained.

The orientation of the magnetic field lines 400 may be controlled during the sputter deposition process. Such kind of control of the magnetic field line orientation may be performed by adjusting an orientation of the magnetic field generator 300 as a whole, or by adjusting individual magnetic elements, i.e. by adjusting the permanent magnets 301, 302, etc. with respect to the substrate surface 501. Thus, Fig. 3 exhibits traces 401 of charged particles which show a reflection behavior and a partial reflection behavior.

As the magnetic field may only interact with charged particles, a predetermined separation of ionized and neutral particles (atoms, molecules) may be provided. A magnetic field intensity may be adapted to a q/m factor of the ionized particles, wherein q is the charge of the ionized particles and m is the mass of the ionized particles.

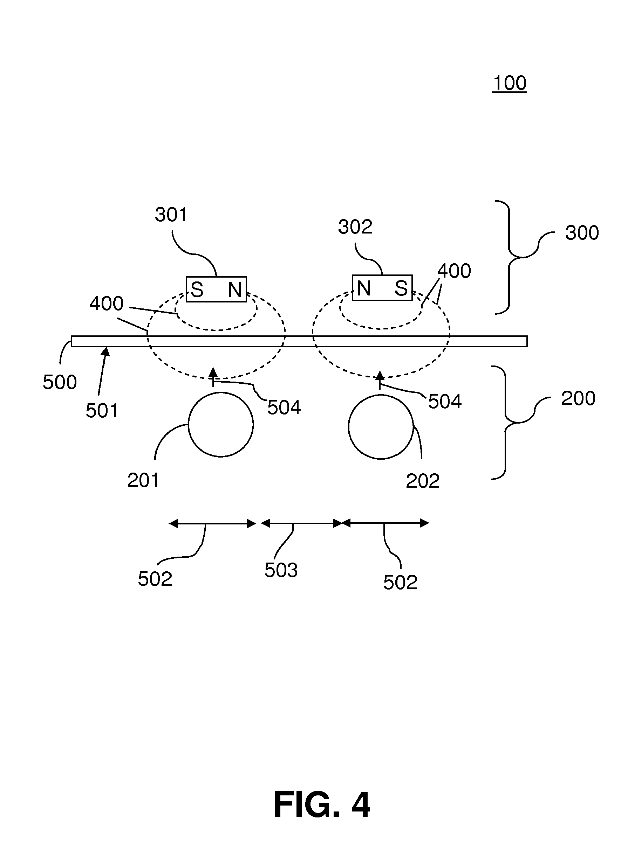

Fig. 4 is a side sectional view of a sputter deposition system 100 in accordance with a second embodiment. It is noted here that components and parts which have been described with respect to previous figures are not detailed in the description with respect to the following figures in order to avoid a redundant description. Again, as in the sputter deposition system illustrated in Figs. 1, 2 and 3, a cathode target spacing, i.e. a distance between adjacent cathode targets 201, 202 may correspond to a spacing of the magnetic elements 301, 302.

Compared to the sputter deposition system 100 of the first embodiment shown in Figs. 1, 2 and 3, the sputter deposition system 100 according to the second embodiment has a different magnetic field configuration of the magnetic field generator 300. As shown in Fig. 4, magnetic elements, i.e. a first permanent magnet 301 and a second permanent magnet 302, are arranged at a side of the substrate 500 opposing the high deposition portions 502 where the first and second cathode targets 201, 202 are provided. A magnetic shielding may be provided by a magnetic field generated by means of the magnetic elements 301, 302. Predetermined portions of the substrate surface 501 may thus be shielded from incoming charged particles of deposition material. In order to provide such kind of magnetic shielding the direction and/or the intensity of the magnetic field may be controlled. Due to the action of Lorentz forces a movement of charged particles in directions perpendicular to the magnetic field lines is restricted, whereas a movement parallel to the magnetic field lines is allowed.

The permanent magnets 301, 302 provided in the second embodiment are arranged such that magnetic poles of the same polarity (N pole and S pole, respectively) are opposing each other. The magnetic elements (the permanent magnets) are arranged adjacent to each other such that magnetic field orientations of the magnetic elements 301, 302 are approximately parallel to the substrate surface. The resulting magnetic field lines 400 are provided similar to Figs. 1 and 2. The magnetic field lines 400 extend substantially parallel to the substrate surface 501 of the substrate 500 to be coated in the high deposition portions 502, wherein the magnetic field lines 400 exhibit a component perpendicular to the substrate surface 501 in a region between two adjacent high deposition portions, i.e. in the low deposition portion 503.

It is noted here that the magnetic field generator 300 may be adapted for providing a magnetic field at the edges of the substrate which is different from a magnetic field provided in a central region of the substrate. In addition to that, the magnetic field generator may include a two-dimensional array of magnetic elements. If a two-dimensional array of magnetic elements is provided, the layer thickness homogeneity may be controlled two-dimensionally, i.e. an inhomogeneity in a deposition rate resulting from local cathode targets 201, 202 may be compensated in two dimensions.

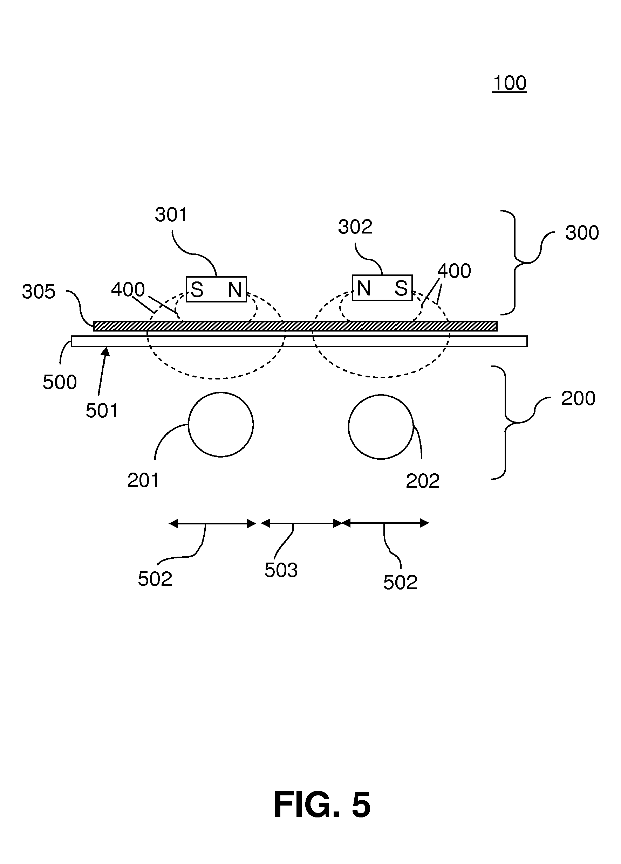

Fig. 5 is a side sectional view of the sputter deposition system shown in Fig. 4 wherein in the system illustrated in Fig. 5 a cooling plate 305 is provided between the substrate 500 and the magnetic field generator 300. The cooling plate 305 arranged between the magnetic field generator 300 and the position of the substrate 500 is adapted for providing a thermal isolation between the magnetic field generator 300 and the substrate deposition portion of the sputter deposition system 100. The cathode assembly 200 may be operated at high temperatures such that the magnetic field generator 300 is thermally isolated by means of the cooling plate 305. According to yet further embodiments, which can be combined with any of the other embodiments and modifications described herein the magnetic elements 301, 302, 303 of the magnetic field generator 300 may be arranged directly onto the cooling plate 305.

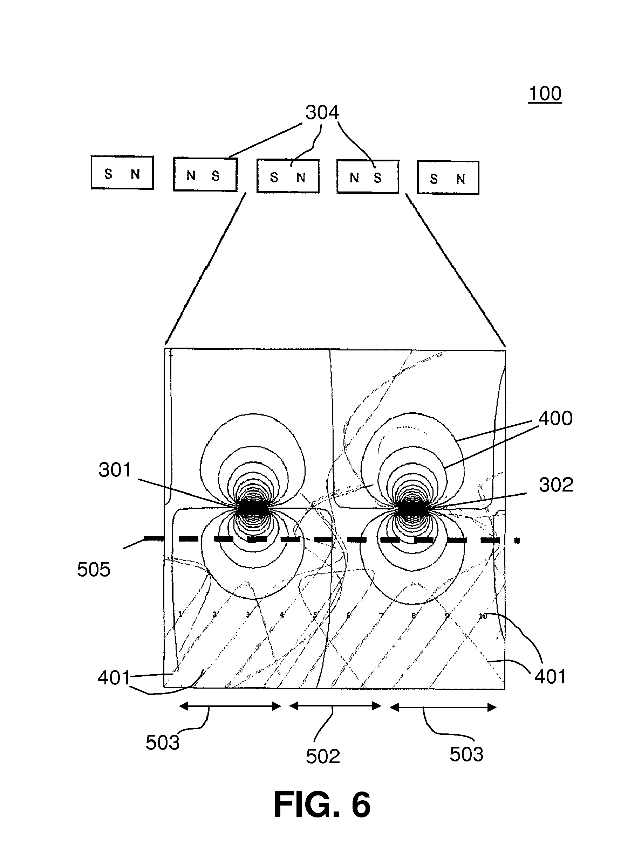

Fig. 6 is a graph corresponding to the graph in Fig. 3, wherein charged particle traces 401 are shown to depend on the arrangement of the magnetic field. Compared to the graph shown in Fig. 3, the graph shown in Fig. 6 is based on the magnetic field configuration of the magnetic field generator 300 described herein above with respect to Fig. 4. The magnetic elements, i.e. the permanent magnets 304 are arranged such that at least two magnetic elements are located adjacent to each other such that magnetic field orientations of the magnetic elements are approximately parallel to the substrate surface, wherein the poles of the same polarity (N pole and S pole, respectively) are opposing each other. The magnetic field distribution is shown by solid lines 400, wherein charged particle traces are shown by dotted and dash-dotted lines 401, respectively. A reference numeral 505 denotes the position of the substrate 500 (see Fig. 4).

It is noted here that, in contrast to the first embodiment described herein above with respect to Figs. 1, 2 and 3, the magnetic elements 304 of the sputter deposition system 100 in accordance with the second embodiment are arranged at a location at the backside of the substrate 500 opposing the position of the cathode target 201, 202. The magnetic field lines 400 again exhibit components substantially parallel to the substrate surface 501 (Fig. 4) in the high deposition portion 502, wherein components perpendicular to the substrate surface 501 are provided in a low deposition portion 503 located between two adjacent high deposition portions 502. In the high deposition portions 502, a reflection of charged particles occurs more often than in the low deposition portion 503, as indicated by the charged particle traces 401.

Fig. 7(a) illustrates a sputter deposition system 100 including a cathode assembly having a plurality of cathode targets 203, a magnetic field generator 300 and a cooling plate 305 arranged between the cathode assembly 200 and the magnetic field generator 300. The magnetic field generator 300 includes a plurality of magnetic elements 304, e.g. permanent magnets which may be arranged at the cooling plate 305.

Between the cooling plate 305 and the cathode assembly 200 the substrate 500 the surface of which may be coated is arranged. The arrangement of the magnetic elements 304 is in accordance with the second embodiment described herein above with respect to Figs. 4, 5 and 6, i.e. the magnetic elements 304 are arranged opposing the cathode targets 203 of the cathode assembly 200 with respect to the substrate 500. Thus a cathode target spacing 605, i.e. a distance between adjacent cathode targets 203, corresponds to a spacing 606 of the magnetic elements 304. It is noted here, however, that a regular spacing 605 of the cathode targets 203 shown in Fig. 7(a) and a corresponding regular spacing 606 of the magnetic elements 304 is not required, rather arbitrary spacings may be provided as long as the magnetic elements 304 are arranged such that they are opposing the cathode targets 203 of the cathode assembly 200 with respect to the substrate 500.

Fig. 7(b) is a graph illustrating layer thickness distributions 603, 604. Respective layer thickness distributions 603, 604 which have been measured at the substrate surface 501 are plotted as a function of a distance along the substrate surface, i.e. the layer thickness 602 is shown as a function of the substrate extension (e.g. a substrate length) in a direction of an arrow 601. A first layer thickness distribution 603 corresponds to a situation where a magnetic field generated by the magnetic field generator 300 is switched off, i.e. a situation is depicted where no magnetic elements are present or where magnetic elements which are provided as electromagnetic coils are switched off. The first layer thickness distribution 603 shows a comparatively large variation in thickness resulting in a large thickness inhomogeneity.

A reference numeral 604 denotes a second layer thickness distribution which is provided at the surface 501 of the substrate, if the magnetic field of the magnetic field generator 300 is switched on, or if permanent magnets 403 are present at locations opposing the respective cathode targets 203.

Compared to the first layer thickness distribution 603, the second layer thickness distribution 604 has much less ripple such that a film thickness homogeneity is increased. Thus it can be seen that by applying the magnetic field generated by the magnetic field generator 300 according to one of the embodiments described herein above a sputter deposition process is improved. According to at least one of the embodiments described herein above, a cathode target spacing 605 of the cathode assembly 200 corresponds to a magnetic element spacing 606 of the magnetic field generator 300, i.e. a cathode target spacing 605 between two adjacent cathode targets 203 coincides with a spacing 606 of the magnetic elements 304 of the magnetic field generator 300.

Albeit not shown in Fig. 7(a), the magnetic field generator 300 may include a two-dimensional array of magnetic elements 304 the spacing of which may be in accordance with the (two-dimensional) spacing 605 of an array of adjacent cathode targets 203. Albeit a regular spacing of cathode targets 203 and a regular spacing of magnetic elements 304 are shown, the present embodiment is not restricted to a regular spacing, rather arbitrary and varying spacings between the cathode targets 203 and the magnetic elements 304 may be provided as long as the spacings 605 of the cathode targets 203 correspond to the spacings 606 of the magnetic elements 304 on a local scale.

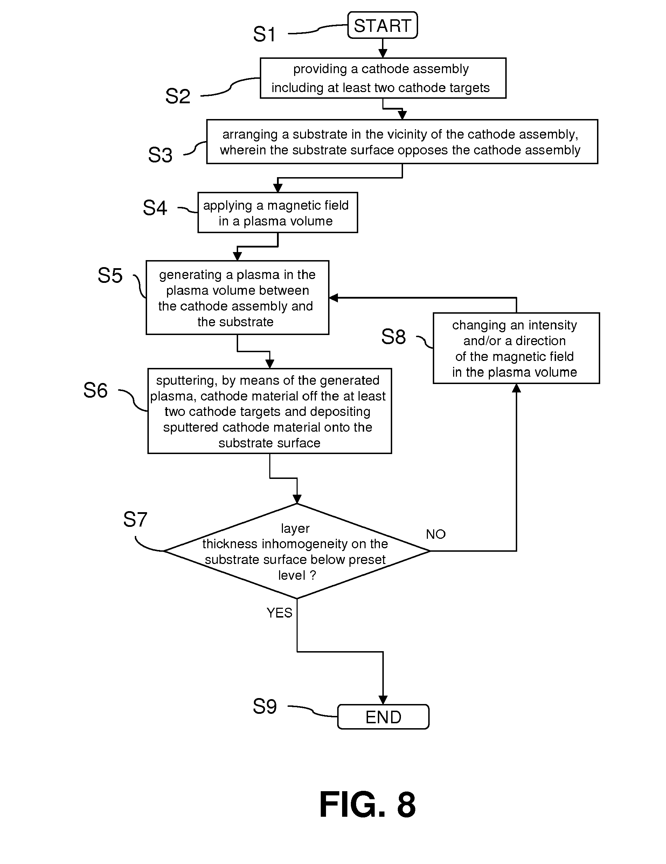

Fig. 8 is a flowchart illustrating a method for depositing a thin film onto a surface of a substrate. At a step S1, the procedure is started. A following step S2 serves as a step for providing a cathode assembly which includes at least two cathode targets 203 (see sputter deposition system 100 described herein above with respect to previous figures).

Then, in a step S3 a substrate 500 is arranged in the vicinity of the cathode assembly. The substrate surface to be coated, i.e. a front surface 501 of the substrate 500 opposes the cathode assembly. In a step S4, a magnetic field is applied in a plasma volume which is defined between the surface of the substrate and the cathode targets of the cathode assembly.

Then in a step S5 a plasma in the plasma volume between the cathode assembly and the substrate is generated. The plasma may be generated by a magnetron device, as described herein above with respect to Fig. 1. Then a sputtering step S6 may follow where cathode material is sputtered off the at least two cathode targets by means of the plasma generated in the plasma volume. The sputtered cathode material is deposited onto the substrate surface.

In a following step S7, it is determined whether the layer thickness inhomogeneity on the substrate surface is below a preset level. This determination step S7 includes measuring the layer thickness at various positions across the substrate surface. If it is determined, in the step S7, that the layer thickness inhomogeneity on the substrate surface is below the preset level ("YES" in the step S7), the procedure is ended in a step S9.

If it is determined in the step S7 that the layer thickness inhomogeneity on the substrate surface is not below the preset level, ("NO" in the step S7), then a step S8 may follow where an intensity and/or a direction of the magnetic field in the plasma volume may be changed. Such changing of the intensity and/or the direction of the magnetic field in the plasma volume changes the shielding effect of the magnetic field lines 400 with respect to incoming ionized particles (described herein above with respect to the previous figures).

After changing the intensity and/or the direction of the magnetic field in the plasma volume in the step S8, again a plasma in the plasma volume between the cathode assembly and the substrate is generated in step 5. Then, again material is sputtered off the cathode targets (step S6) and a determination with respect to the layer thickness inhomogeneity is carried out in the step S7.

After ending the procedure in the step S9, the sputter deposition system 100 has a preset adjustment such that the sputter deposition system 100 is calibrated for low layer thickness inhomogeneity, i.e. for a layer thickness inhomogeneity below the preset level, see also Fig. 7(b) described herein above.

The step of sputtering, by means of the generated plasma, cathode material of the at least two cathode targets and depositing sputtered cathode material onto the substrate surface in a deposition direction, includes sputtering with a high deposition rate in high rate deposition portions of the substrate surface which are opposing respective cathode targets, and sputtering with a low deposition rate in a low rate deposition portion between the two adjacent high rate deposition portions of the substrate surface.

The above step S7 of applying a magnetic field in the plasma volume includes applying a magnetic field in the plasma volume such that the difference between the high deposition rate and the low deposition rate is compensated, see second layer thickness distribution 604 as compared to first layer thickness distribution 603 depicted in Fig. 7(b) above.

The magnetic field may be controlled with respect to the magnetic field direction and/or the magnetic field strength. The magnetic field strength may be adjusted by adjusting a distance between the magnetic field generator 300 and the substrate surface. The orientation of the magnetic field lines 400 is adjusted by adjusting an orientation of the magnetic field generator. Furthermore, the magnetic field orientation may be controlled during the thin film deposition process.

The magnetic field may be applied such that at least one sub volume of the plasma volume adjacent to at least one high rate deposition portion of the substrate is penetrated by a high density of magnetic field lines 400, wherein the remaining plasma volume is penetrated by a low density of magnetic field lines 400. The magnetic field may be adjusted such that the sub volume extends from at least one high rate deposition portion of the substrate surface towards an opposing cathode target and includes a volume in a range from 30% to 70%, and typically approximately 50% of the plasma volume.

In light of the above, a plurality of embodiments have been described. For example, according to one embodiment, a sputter deposition system adapted for depositing a thin film onto a substrate surface is provided. The system includes a cathode assembly including at least two cathode targets opposing the substrate surface and adapted for providing cathode material for forming the thin film; a plasma source adapted for generating a plasma for sputtering cathode material off the at least two cathode targets, wherein two or more high rate deposition volumes are defined between portions of the substrate surface opposing a respective cathode target and the cathode target, and wherein a low rate deposition volume is defined between the two adjacent high rate deposition volumes; and a magnetic field generator adapted for providing a magnetic field which is controllable independently of the plasma source such that magnetic field lines extend substantially parallel to the substrate surface in at least portions of the high rate deposition volumes. According to an optional modification thereof the magnetic field generator is adapted to provide the substantially parallel magnetic field lines penetrating the high rate deposition volumes at or near the substrate surface. According to another optional modification thereof the magnetic field generator is adapted to provide that the magnetic field strength of the magnetic field is decreasing with increasing distance to the cathode target. Furthermore, the plasma source may include at least one magnetron for each cathode target. According to yet further embodiments, which can be combined with other embodiments described herein, the magnetic field generator is arranged at a side of the substrate opposing the substrate surface to be coated. According to yet further additional or alternative modifications the magnetic field generator includes at least one magnetic element of the group consisting of: a permanent magnet, an electromagnetic coil, and combinations thereof. According to yet further embodiments, which can be combined with any of the other embodiments and modifications above, at least two magnetic elements are arranged adjacent to each other such that magnetic field orientations of two adjacent magnetic elements are anti-parallel to each other and about perpendicular to the substrate surface, respectively. Moreover, according to another optional modification at least two magnetic elements are arranged adjacent to each other such that magnetic field orientations of the magnetic elements are approximately parallel to the substrate surface. According to yet further embodiments, which can be combined with any of the other embodiments and modifications above, a cathode target spacing between the at least two cathode targets corresponds to a spacing of the magnetic elements of the magnetic field generator. According to yet further additional or alternative modifications at least one cooling plate is provided between the magnetic field generator and a position of the substrate. According to another embodiment, the magnetic field generator is adapted for providing a magnetic field at the edges of the substrate which is different from a magnetic field provided in a central region of the substrate. Furthermore, according to yet further embodiments, which can be combined with any of the other embodiments and modifications above the magnetic field generator may include includes a two-dimensional array of magnetic elements. According to another embodiment, a method of depositing a thin film onto a surface of a substrate is provided. The method includes steps of providing a cathode assembly including at least two cathode targets; arranging the substrate in the vicinity of the cathode assembly, wherein the substrate surface opposes the cathode assembly; generating a plasma in a plasma volume between the cathode assembly and the substrate; sputtering, by means of the generated plasma, cathode material off the at least two cathode targets and depositing sputtered cathode material onto the substrate surface in a deposition direction with a high deposition rate in high rate deposition portions of the substrate surface which are opposing respective cathode targets, and with a low deposition rate in a low rate deposition portion between the two adjacent high rate deposition portions of the substrate surface; and applying a magnetic field in the plasma volume such that the difference between the high deposition rate and the low deposition rate is compensated. In addition to that applying the magnetic field may include providing magnetic field lines extending perpendicular to the deposition direction in the high rate deposition portions. According to yet further additional or alternative modifications the magnetic field is controlled with respect to a magnetic field direction and/or a magnetic field strength. According to an optional modification thereof, the magnetic field strength is adjusted by adjusting a distance between a magnetic field generator and the substrate surface. In addition to that, or alternatively, the orientation of the magnetic field lines is adjusted by adjusting an orientation of the magnetic field generator. According to an optional modification thereof, the magnetic field orientation is controlled during the thin film deposition process. According to yet further embodiments, which can be combined with any of the other embodiments and modifications above, the thin film deposition process includes processing steps selected from the group consisting of depositing a uniform thin film onto the substrate surface, depositing a layer stack onto the substrate surface, non-reactive processing of the substrate surface, reactive processing of the substrate surface, and any combination thereof. According to yet further additional or alternative modifications sputtering cathode material off the at least two cathode targets is performed by magnetron sputtering. According to yet further additional or alternative modifications the magnetic field is applied such that at least one sub volume of the plasma volume adjacent to at least one high rate deposition portion of the substrate surface is penetrated by a high density of magnetic field lines, wherein the remaining plasma volume is penetrated by a low density of magnetic field lines. According to yet further additional or alternative modifications the magnetic field is adjusted such that the sub volume extends from at least one high rate deposition portion of the substrate surface towards an opposing cathode target and includes a volume in a range from 30 % to 70 %, and typically about 50 %, of the plasma volume.

While the foregoing is directed to embodiments of the invention, other and further embodiments of the invention may be devised without departing from the basic scope thereof, and the scope thereof is determined by the claims that follow.

## Claims

1. A sputter deposition system adapted for depositing a thin film onto a substrate surface, the system comprising:
a cathode assembly comprising at least two cathode targets opposing the substrate surface and adapted for providing cathode material for forming the thin film;
a plasma source adapted for generating a plasma for sputtering cathode material off the at least two cathode targets, wherein two or more high rate deposition volumes are defined between portions of the substrate surface opposing a respective cathode target and the cathode target, and wherein a low rate deposition volume is defined between the two adjacent high rate deposition volumes; and
a magnetic field generator adapted for providing a magnetic field which is controllable independently of the plasma source such that magnetic field lines extend substantially parallel to the substrate surface in at least portions of the high rate deposition volumes.

2. The system in accordance with any one of the preceding claims, wherein the magnetic field generator is adapted to provide the substantially parallel magnetic field lines penetrating the high rate deposition volumes at or near the substrate surface.

3. The system in accordance with any one of the preceding claims, wherein the magnetic field generator is adapted to provide that the magnetic field strength of the magnetic field is decreasing with increasing distance to the cathode target.

4. The system in accordance with any one of the preceding claims, wherein each cathode target is provided as a magnetron.

5. The system in accordance with any one of the preceding claims, wherein the magnetic field generator is arranged at a side of the substrate opposing the substrate surface to be coated.

6. The system in accordance with any one of the preceding claims, wherein the magnetic field generator comprises at least one magnetic element of the group consisting of: a permanent magnet, an electromagnetic coil, and combinations thereof.

7. The system in accordance with claim 6, wherein a cathode target spacing between the at least two cathode targets corresponds to a spacing of the magnetic elements of the magnetic field generator.

8. The system in accordance with claim 6 or 7, wherein at least two magnetic elements are arranged adjacent to each other such that magnetic field orientations of two adjacent magnetic elements are anti-parallel to each other and about perpendicular to the substrate surface, respectively.

9. The system in accordance with any one of the claims 6 to 8, wherein at least two magnetic elements are arranged adjacent to each other such that magnetic field orientations of the magnetic elements are approximately parallel to the substrate surface.

10. The system in accordance with any one of the preceding claims, wherein a cooling plate is provided between the magnetic field generator and a position of the substrate.

11. The system in accordance with any one of the preceding claims, wherein the magnetic field generator comprises a two-dimensional array of magnetic elements.

12. A method for depositing a thin film onto a surface of a substrate, the method comprising:
providing a cathode assembly comprising at least two cathode targets;
arranging the substrate in the vicinity of the cathode assembly, wherein the substrate surface opposes the cathode assembly;
generating a plasma in a plasma volume between the cathode assembly and the substrate;
sputtering, by means of the generated plasma, cathode material off the at least two cathode targets and depositing sputtered cathode material onto the substrate surface in a deposition direction with a high deposition rate in high rate deposition portions of the substrate surface which are opposing respective cathode targets, and with a low deposition rate in a low rate deposition portion between two adjacent high rate deposition portions of the substrate surface; and
applying a magnetic field in the plasma volume such that the difference between the high deposition rate and the low deposition rate is compensated.

13. The method in accordance with claim 12, wherein applying the magnetic field comprises providing magnetic field lines extending perpendicular to the deposition direction in the high rate deposition portions.

14. The method in accordance with claim 12 or 13, wherein a magnetic field strength is adjusted by adjusting a distance between a magnetic field generator and the substrate surface, and/or an orientation of the magnetic field lines is adjusted by adjusting an orientation of the magnetic field generator.

15. The method in accordance with any one of the claims 12 to 14, wherein the magnetic field is applied such that at least one sub volume of the plasma volume adjacent to at least one high rate deposition portion of the substrate surface is penetrated by a high density of magnetic field lines, wherein the remaining plasma volume is penetrated by a low density of magnetic field lines.
